# EUROPEAN PATENT SPECIFICATION

(11) **EP 2 887 777 B1**
(45) Date of publication and mention of the grant of the patent: **13.04.2022**
(21) Application number: 14197188.7
(22) Date of filing: 10.12.2014
(51) Int. Cl.: H05K 1/02, H02K 11/00, H05K 1/11, H02K 5/22, H02K 11/33

(54) **A PCB Strip**
Leiterplattenstreifen
Bande de PCB

(30) Priority: 17.12.2013 CH 20902013
(43) Date of publication of application: 24.06.2015
(73) Proprietor: Faulhaber Precistep SA, 2300 La Chaux-de-Fonds (CH)
(72) Inventor: Monnin, Jonas, 2333 La Ferrière (CH); Moser, Yves, 2300 La Chaux-de-Fonds (CH); Bellamy, Justine, 25130 Villers-le-Lac (FR)
(74) Representative: P&TS SA (AG, Ltd.)

(56) References cited:
- GB-A- 2 341 980
- US-A- 4 689 023
- US-A1- 2002 130 568
- US-B1- 6 274 819
- US-B1- 8 007 286

## Description

### Field of the invention

The present invention concerns a PCB strip, and in particular to a PCB strip which comprises a plurality of cutting zones; the PCB strip can be selectively cut along one of the cutting zones to select one of a plurality of connecting zones for electrically connecting to a driver and/or can be selectively cut along one of the cutting zones to select one of two electrical configurations for electrical contacts on the PCB strip and/or the PCB strip.

### Description of related art

It is known to use PCB strips to electrically connect windings of a stator to a driver such as a power source. However, existing PCB strips have a fixed physical and electrical configuration; for example PCB strips have a fixed length and/or may have a fixed pitch between conductors in the PCB strip; or the PCB strips are configured to connect the windings in single electrical configuration e.g. either parallel or series. Different applications require different configurations for the PCB strip; consequently individual PCB strips must be provided for each application. This poses a number of problems, firstly a user can use a PCB strip only for the application for which it was configured; existing PCB strips do not provide any means by which the user can reconfigure the PCB strip. Secondly, different manufacturing processes are required to manufacture each of the differently configured PCB strips which lead to high manufacturing costs.

US2002130568 discloses a device for transferring electric currents that includes a slip ring unit that has a rotor with connecting wires and a stator and a printed circuit board fastened to the rotor. The printed circuit board includes connectors in electrical contact with the connecting wires. A torque required for rotary movement between the rotor and the stator is introduced via the printed circuit board.

GB2341980 discloses a circuit board comprising an insulating substrate and a plurality of electrically conductive connection pads on the substrate, for electrical connection to another device. The pads are arranged in sets with a plurality of pads in each set. The circuit board further includes circuit tracks which electrically interconnect a corresponding pad in each respective set. The circuit board may be cut with scissors to provide desired circuit configurations

It is an aim of the present invention to mitigate or obviate at least some of the above-mentioned disadvantages.

### Brief summary of the invention

The present invention is as defined in the appended claims.

According to an aspect of the present invention there is provided a PCB strip comprising, a first connecting portion which comprises a plurality of electrical contacts which can be electrically connected to windings on a stator, a second connecting portion which can be electrically connected to a driver, and a third connecting portion which can be electrically connected to a driver; wherein, said plurality of electrical contacts are electrically connected so as to provide two selectable electrical configurations; and wherein the PCB strip comprises a first cutting zone at which the PCB strip can be cut to select one of the two selectable electrical configurations for the electrical contacts of the first connecting portion, and a second cutting zone at which the PCB strip can be cut to select the other of the at least two selectable electrical configurations for the electrical contacts of the first connecting portion.

The electrical contacts on the first connecting portion can be electrically connected to windings on the stator. The electrical contacts on the first connecting portion can be directly electrically connected to windings of the stator. Preferably each wire which defines a respective winding of the stator is directly connected to the electrical contacts on the first connecting portion. Preferably each wire is soldered to an electrical contact of the first connecting portion. Preferably two wires which define a single winding of the stator are directly connected to the electrical contacts of the first connecting portion. Alternatively the electrical contacts on the first connecting portion can be electrically connected to windings of the stator by means of a conductor wires which are connected to the windings and electrical contacts of the first connecting portion. The conductor wires are preferably connected by soldering to the windings and connected by soldering to electrical contacts of the first connecting portion.

The at least two selectable electrical configurations comprise, a first electrical configuration which is such that when electrical contacts of the first portion are connected to windings of the stator those windings are connected electrically in parallel, and a second electrical configuration which is such that when electrical contacts of the first portion are connected to windings of the stator those windings are connected electrically in series.

The first cutting zone may be provided at a junction between the first connecting portion and the second connecting portion and wherein the second cutting zone may be provided at a junction between the first connecting portion and the third connecting portion.

The PCB strip may comprise, a first electrical contact and a first conductor which electrically connects the first electrical contact to a first conductor in the second connecting portion; a second and third electrical contact and a second conductor, wherein the second electrical contact is electrically connected to the third electrical contact by the second conductor; a fourth electrical contact and a third conductor which electrically connects the fourth electrical contact to a second conductor in the second connecting portion; a fifth electrical contact and a fourth conductor which electrically connects the fifth electrical contact to a third conductor in the second connecting portion; a sixth and seventh electrical contact and a fifth conductor, wherein the sixth electrical contact is electrically connected to the seventh electrical contact by the fifth conductor; an eight electrical contact and a sixth conductor which electrically connects the eight electrical contact to a fourth conductor in the second connecting portion.

The first, second, third, fourth, fifth and sixth electrical conductors may be each arranged to traverse the first cutting zone. Preferably the first, second, third, fourth, fifth and sixth electrical conductors are each arranged to traverse the first cutting zone only.

The PCB strip may comprise, a seventh conductor which electrically connects the first and third electrical contacts and is electrically connected to a first conductor in the third connecting portion; an eight conductor which electrically connects the second and fourth electrical contacts and is electrically connected to a second conductor in the third connecting portion; a ninth conductor which electrically connects the fifth and seventh electrical contacts and is electrically connected to a third conductor in the third connecting portion; a tenth conductor which electrically connects the sixth and eight electrical contacts and is electrically connected to a fourth conductor in the third connecting portion.

The seventh, eight, ninth, and tenth conductors may each arranged to traverse the second cutting zone. Preferably the seventh, eight, ninth, and tenth conductor are each arranged to traverse the second cutting zone only. In the most preferred embodiment the first, second, third, fourth, fifth and sixth electrical conductors are each arranged to traverse the first cutting zone and wherein the seventh, eight, ninth, and tenth conductor are each arranged to traverse the second cutting zone.

The third connecting portion may be arranged to extend along the same axis at the second connecting portion.

The PCB strip may be configured to be cross-shaped.

The third connecting portion may be arranged to extend along a different axes to the axis along which the second connecting portion extends, and wherein the axis along which the third connecting portion extends may be parallel to the axis along which the second connecting portion extends.

The PCB strip may be configured to be c-shaped or to have an inverted-c-shape.

The length of the third connecting portion may be different to the length of the second connecting portion. The length of the third connecting portion may be equal to the length of the second connecting portion.

The second connecting portion and/or third connecting portion may comprise, a plurality of discrete connecting zones along the length of the respective connecting portion, each connecting zone comprising electrical contacts, where the electrical contacts of a connecting zone are suitable for electrically connecting to a driver when that connecting zone is closest to a free end of the respective connecting portion; and a plurality of cutting zones at which the respective connecting portion can be cut to define the free end of the respective connecting portion so as to select one of the plurality of connecting zones whose electrical contacts are to be electrically connected to a driver.

At least some of the plurality of connecting zones in the second and/or third connecting portion may differ in that they comprise electrical contacts are which arranged in different configurations.

The pitch between electrical contacts in one of the connecting zones may be different to the pitch between electrical contacts other one of the connecting zones; and/or wherein the electrical contacts in one of the connecting zones may be defined by Zero Insertion Force (ZIF) or Low Insertion Force (LIF) contacts and the electrical contacts of another one of the connecting zones may be defined by vias which can receive wire conductors; and/or wherein the electrical contacts in one of the connecting zones may be defined by ZIF or LIF contacts and the electrical contacts of another one of the connecting zones may be defined by pads which can receive wire conductors.

The second and third connecting portions may each comprise conductor lines which are electrically connected to the electrical contacts of the first connecting portion.

The PCB strip preferably comprises at least two layers. The layers are preferably stacked so that the PCB strip is a laminar structure. Preferably the PCB strip comprises a first layer which comprises insulating material. Preferably the insulating material is flexible. Preferably the PCB strip comprises a second layer. Preferably the second layer comprises conducting metal. The conducting metal may be configured as a layer. The PCB strip may additionally comprise a third layer. The third layer may comprises flexible insulating material. The PCB strip may additionally comprise a rigid layer. The first layer may be mounted on the rigid layer at one or more of the connecting zones so that the PCB strip has increased rigidity at the one or more connecting zones and/or so that PCB strip has increased thickness at the one or more connecting zones.

The conductor lines may be insulated by insulating material, and at least some of the plurality of connecting zones in the second and/or third connecting portions are defined by areas where the insulating material is absent so as to expose the conductor lines. The insulating material may be provided as a layer. Preferably the insulating material is the insulating material which defines a third layer of PCB strip. Preferably the PCB strip is configured to be stiffer at the connecting zones than at the other parts of the second connecting portion. This may be achieved for example by mounting the first layer on the rigid layer at the connecting zones. Preferably each cutting zone is defined by an end extremity of a respective connecting zone which is furthest from the first connecting portion.

The second and/or third connecting portions may comprise a tapered profile between at least two successive connecting zones.

Each of the cutting zones may be provided adjacent to a connecting zone.

The first connecting portion may be configured to have a circular profile.

The second connecting portion may extend from the first connecting portion along an axis which is perpendicular to a tangent to the first connecting portion and the third connecting portion may extend from the first connecting portion along an axis which is perpendicular to a tangent to the first connecting portion.

The first connecting portion may be configured to have a rectangular profile.

The first, second and third connecting portion may be arranged such that the PCB strip is cross-shaped.

The first connecting portion may be configured to be flexible so that it can wrap around a stator.

The second and/or third connecting portions may be configured to be flexible.

The first connecting portion may comprise adhesive material.

The first connecting portion may comprise electrical contacts which can be electrically connected to windings of a stator. The electrical contacts of the first connecting portion can be directly electrically connected to windings of the stator. Preferably each wire which defines a respective winding of the stator is directly connected to the electrical contacts on the first connecting portion. Preferably each wire is soldered to an electrical contact on the first connecting portion. Preferably two wires which define a single winding of the stator are directly connected to the electrical contacts on the first connecting portion. Alternatively the electrical contacts are electrically connected to windings of a stator by conductive wires; for each electrical contact on the first connecting portion a respective conductive wire may be soldered to that electrical contact and to a respective winding, or a plurality of windings, of the stator.

According to a further aspect of the present invention there is provided an assembly comprising an electrical motor which comprises a stator which comprises windings, and a PCB strip according to the present invention.

The electrical motor may further comprise a rotor which comprises a shaft, and wherein the first connecting portion of the PCB strip is wrapped around the stator so that the electrical contacts of the first connecting portion may be electrically connected to windings of the stator, and wherein the second connecting portion or third connecting portion of the PCB strip is arranged to extend axially from the stator, parallel to the shaft. The electrical motor is preferably a stepping motor.

The motor may further comprise a housing in which stator is housed, and wherein the first connecting portion of the PCB strip is located between the stator and an inner surface of the housing.

According to a further aspect of the present invention there is provided a method of manufacturing an assembly which comprises a stator and a PCB strip according to the present invention, the method comprising the steps of,
(a) electrically connecting electrical contacts of the first connecting portion to the windings of a stator
(b) choosing an electrical configuration for the windings of a stator;
(c) cutting a PCB strip at the first cutting zone if the first electrical configuration corresponds to the chosen configuration for the windings of a stator, or cutting a PCB strip at the second cutting zone if the second electrical configuration corresponds to the chosen configuration for the windings of a stator.

The steps may be carried out in the following order, step (a) is carried out first, followed by step (b), followed by step (c).

The step of electrically connecting electrical contacts of the first connecting portion to the windings of a stator may comprise wrapping the first connecting portion around the stator. The step of electrically connecting electrical contacts of the first connecting portion to the windings of a stator may comprise, directly connecting the windings of a stator to electrical contacts of the first connecting portion. Preferably the step comprises directly connecting each wire which defines a respective winding of the stator to the electrical contacts of the first connecting portion. Preferably each wire is soldered to an electrical contact of the first connecting portion. Preferably two wires define a single winding of the stator, and the step of electrically connecting electrical contacts of the first connecting portion to the windings of a stator, directly connecting the two wires of each windings of a stator to electrical contacts of the first connecting portion. Alternatively, the step of electrically connecting electrical contacts of the first connecting portion to the windings of a stator may comprise using conductor wires to electrically connect each of the electrical contacts of the first connecting portion to one or more windings of a stator. The step may further comprise soldering each of the conductor wires to a respective electrical contact of the first connecting portion and to a respective winding of a stator or to a plurality of windings on the stator.

The PCB strip may comprise a first, second and third connecting portions and the method may comprise the step of selecting between the second and third connecting portion and cutting the PCB strip at a cutting zone to remove the selected second or third connecting portion.

### Brief Description of the Drawings

The invention will be better understood with the aid of the description of an embodiment given by way of example and illustrated by the figures, in which:
Fig. 1 shows a plan view of a PBC strip according to an illustrative example not part of the present invention;
Fig. 2 shows a plan view of a PBC strip according to an illustrative example not part of the present invention;
Fig. 3 shows a plan view of a PBC strip according to an illustrative example not part of the present invention;
Fig. 4 shows a plan view of a PBC strip according to an embodiment of the present invention;
Fig. 5 shows a perspective view of an assembly according to an illustrative example not part of the present invention;
Fig. 6 shows a perspective view of an assembly according to a further illustrative example not part of the present invention.

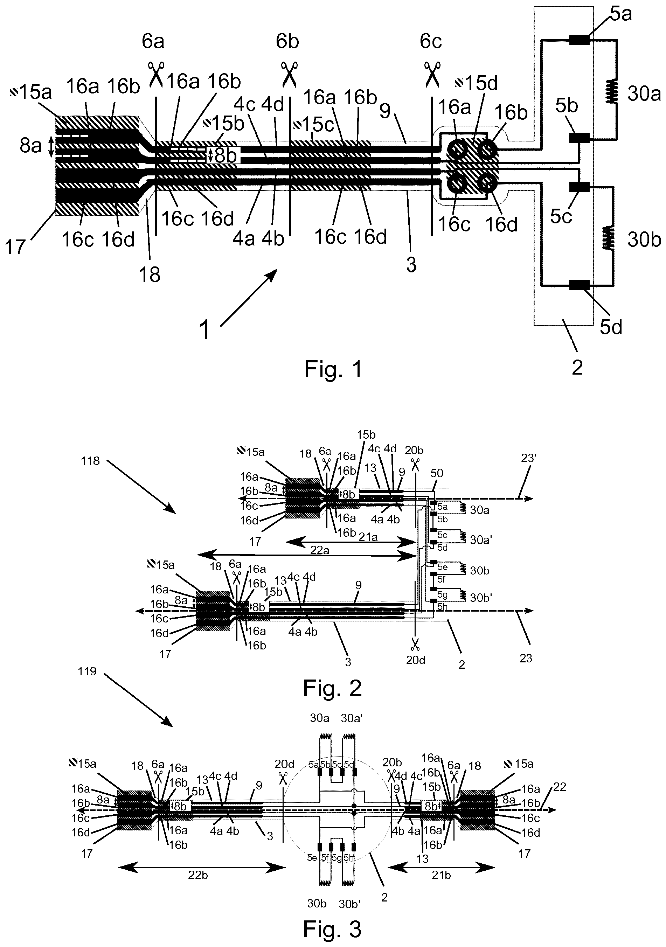

Fig. 1 shows a plan view of a PBC strip 1 according to an illustrative example not part of the present invention.The PCB strip 1 is destined to be electrically connected to an electrical motor; in particularly, but not exclusively, PCB strip 1 is destined to be electrically connected to windings 30a,30b of a stator of a stepper motor and to a driver so as to electrically connect the windings 30a,30b of the stepper motor to a driver. The driver may be for example any suitable power source.

The PCB strip 1 comprises a first connecting portion 2 which comprises four electrical contacts 5a-d which can be electrically connected to windings 30a,30b of a stator (either directly or by conductor wires which are soldered to the electrical contacts 5a-d and windings 30a,30b) . It will be understood that the first connecting portion 2 may comprise any number of electrical contacts.

The PCB strip 1 further comprises a second connecting portion 3 which can be electrically connected to a driver, such as a power source. When the first connecting portion 2 and second connecting portion 3 are simultaneously electrically connected to the respective windings 30a,30b of the stator and to the driver, the PCB strip 1 electrically connects the windings 30a,30b of the stator and driver.

The second connecting portion 3 comprises a plurality of discrete connecting zones 15a-d along the length of the second connecting portion 3. The second connecting portion 3 comprises a tapered profile 18 between at least two successive connecting zones 15a, 15b. Each connecting zone 15a-d comprises electrical contacts 16a-d; the electrical contacts 16a-d of a connecting zone 15a-d are suitable for electrically connecting to electrical contacts of a driver when that connecting zone 15a-d is closest to a free end 17 of the second connecting portion 3.

The second connecting portion 3 comprises a plurality of cutting zones 6a-c at which the second connecting portion 3 can be cut to define the free end 17 of the second connecting portion 3 so as to select one of the plurality of connecting zones 15a-d whose electrical contacts 16a-d are to be electrically connected to a driver. For example, in order to select connecting zone 15b whose electrical contacts 16a-d are to be electrically connected to a driver, one should cut the PCB strip 1 along cutting zone 6a so that the free end 17 of the PCB strip 1 is now defined to be at the cutting zone 6a; in doing so the connecting zone 15b is made closest to the free end 17 of the PCB strip 1 and therefore is selected as the connecting zone 15a-d whose contacts are to be electrically connected to a driver.

As shown in Figure 1, some of the plurality of connecting zones 15a-d in the second connecting portion 3 differ in that they comprise electrical contacts 16a-d which arranged in different configurations. For example, the pitch 8a between electrical contacts 16a-d in the connecting zone 15c is different to the pitch 8b between electrical contacts 16a-d of the connecting zone 15a. A further example is that the electrical contacts 16a-d in the connecting zones 15a-c are defined by Zero-Insertion-Force (ZIF) contacts 16a-d, or Low-Insertion-Force (LIF) contacts 16a-d, and the electrical contacts 16a-d of the connecting zone 15d are defined by vias 16a-d, or pad 16a-d, which can receive wire conductors.

The second connecting portion 3 comprises conductor lines 4a-d which are electrically connected to the electrical contacts 5a-d on the first connecting portion 2. The conductor lines 4a-d are insulated by insulating material 9, and at least some of the plurality of connecting zones 15a-d in the second connecting portion 3 are defined by areas where the insulating material 9 is absent so as to expose the conductor lines 4a-d. The portion of the conductor lines 4a-d which are in the region of the connecting zones 15a-d are configured to be stiffer than the other portions of the conductor lines 4a-d which are insulated by the insulating material 9.

In the example shown in Figure 1 each cutting zone 6a-c is defined by an end extremity of a respective connecting zone 15a-d which is furthest from the first connecting portion 2.

In this particular example the first connecting portion 2 has a rectangular profile. The first and second connecting portions 2,3 are arranged such that the PCB strip 1 is T-shaped. However, it will be understood that the first connecting portion 2 may have any suitable shape; for example in a variation of the aspect the first connecting portion 2 has a circular profile, and second connecting portion 3 extends from the first connecting portion along an axis which is perpendicular to a tangent to the first connecting portion 2.

The first connecting portion 2 is configured to be flexible so that it can wrap around a stator. In the present example the second connecting portion 3 is also configured to be flexible. It will be understood that, alternatively, only one of the first or second connecting portions 2,3 may be flexible, or neither of the first or second portions 2,3 may be flexible. The first connecting portion 2 further comprises adhesive material which facilitates holding the first connecting portion 2 on the stator so that the electrical contacts 5a-d on the first portion 2 remain electrically connected to windings 30a,30b on the stator.

During use the user may wrap the flexible first connecting portion 2 around a stator so that the electrical contacts 5a-d on the first connecting portion 2 may be electrically connected to the windings 30a,30b of the stator. The electrical contacts 5a-d on the first may be directly connected to the windings 30a,30b; in this case each wire which defines a respective winding of the stator is directly connected to the electrical contacts of the first connecting portion. Preferably each wire is soldered to an electrical contact of the first connecting portion. Preferably each winding is defined by two wires, and the two wires of each winding are directly connected to the electrical contacts of the first connecting portion. Alternatively conductor wires will be used to electrically connect the electrical contacts 5a-d to the windings 30a,30b; the conductor wires may be attached by soldering to the electrical contacts 5a-d and the windings 30a,30b. The adhesive of the first connecting portion 2 will facilitate the first connecting portion 2 in maintaining a secure position on the stator.

The user then chooses which of the connecting zones 15a-d whose electrical contacts 16a-d are to be electrically connected to a driver.

The user then cuts the PCB strip 1 at the cutting region 6a-c which is at the end extremity of the chosen connecting zone 15a-d; the PCB strip 1 is thus cut so that chosen connecting zone 15a-d is made to be closest to the free end 17 of the PCB strip 1. Of course it will be understood that it will not be necessary to cut the PCB strip 1 if the user chooses connecting zone 15a as this connecting zone 15a is already closest to the free end 17 of the PCB strip without the need to cut the PCB strip 1.

The electrical contacts 16a-d of the chosen connecting zone 15a-d are then electrically connected to the driver.

It will be understood that, alternatively, the step of selecting a connecting zone 15a-d and the cutting of the PCB strip 1 may be performed before the step of wrapping the flexible first connecting portion 2 around the stator.

Fig. 2 shows a plan view of a PBC strip 118 according to a further illustrative example not part of the present invention. The PBC strip 118 comprises many of the same features and variations as the PCB strip 1 shown in Figure 1 and like features are awarded the same reference numbers.

The PCB strip 118 further comprises a third connecting portion 13. The third connecting portions 13 may comprise some or all of the features of the second connecting portion 3 of the PCB strip 1 shown in Figure 1 and like features are awarded the same reference numbers. Also the second connecting portion 3 may comprise some or all of the features of the second connecting portion 3 of the PCB strip 1 shown in Figure 1 and like features are awarded the same reference numbers.

The first connecting portion 2 comprises eight electrical contacts 5ah which can be electrically connected to the windings 30a,30a',30b,30b' of a stator. It will be understood that the first connecting portion 2 could comprise any number of electrical contacts, for example the first connecting portion 2 could comprise four electrical contacts. The first connecting portion 2 further comprises conductors 50 which connect each of the eight electrical contacts 5a-h to a respective conductor line 4a-d in the second or third connecting portions 3,13. The first connecting portion 2 is shown to be rectantular shaped, however it will be understood that the first connecting portion 2 may have any other suitable shape e.g. circular. The first connecting portion 2 is interposed between the second and third connecting portions 3,13.

Additionally the PCB strip 118 further comprising a first cutting zone 20d along which the PCB strip 118 can be selectively cut to selectively remove the second connecting portion 3 from the PCB strip 118 and a second cutting zone 20b along which the PCB strip 118 can be selectively cut to selectively remove the third connecting portion 13 from the PCB strip 118. The first cutting zone 20d is located at a junction between the first and second connecting portions 2,3 and the second cutting zone 20b is located at a junction between the first and third connecting portions 2,13.

In the example shown in Figure 2 the third connecting portion 13 is arranged to extend along a different axes 23' to the axis 23 along which the second connecting portion 3 extends. The axis 23' along which the third connecting portion 13 extends is parallel to the axis 23 along which the second connecting portion 3 extends. Thus, the PCB strip 118 is c-shaped or has an inverted-c-shape. Figure 2 shows the second and third connecting portions 3,13 attached to the first connecting portion 2 at opposing ends of the first connecting portion 2; thus the axes 23 and 23' are located at opposite ends of the first connecting portion 2; however it will be understood that in a variation of the aspect the second and third connecting portions 3,13 may be attached to the first connecting portion 2 at a position other than at the opposing ends, thus leaving the opposing ends of the first connecting portion 2 as free ends.

Additionally the length 21a of the third connecting portion 13 is different to the length 22a of the second connecting portion 2. In this example the third connecting portion 13 is shorter than the second connecting portion 3. However, it should be understood that in a variation of the aspect both the second and third connecting portions 3,13 have equal length.

Fig. 3 shows a plan view of a PCB strip 119 according to a further illustrative example not part of the present invention. The PCB strip 119 comprises many of the same features and variations as the PCB strip 118 shown in Figure 2 and like features are awarded the same reference numbers. As was the case for the PCB strip 118 shown in Figure 2 the PCB strip 119 shown in Figure 3 comprises a second and third connecting portions 3,13 each of which may comprise some or all of the features of the second connecting portion 3 of the PCB strip 1 shown in Figure 1, and like features are awarded the same reference numbers.

Unlike the PCB strip 118 of Figure 2, in the PCB strip 119 of Figure 3 the second and third connecting portions 3,13 are arranged to extend along the same axis 22. The first connecting portion 2 is shown to be circular shaped and the second and third connecting portions 2,13 each extend from the first connecting portion 2 perpendicular to a tangent to the circular shaped first connecting portion 2. However it will be understood that the first connecting portion 2 may have any other suitable shape e.g. rectangular; so that the PCB strip 119 is cross-shaped for example.

Referring to the illustrative examples not part of the present invention depicted in Figures 2 and 3, during use a user may wrap the flexible first connecting portion 2 around a stator so that the electrical contacts 5a-h on the first connecting portion 2 may be electrically connected to the windings 30a,30b,30a',30b' of the stator. The electrical contacts 5a-h on the first may be directly connected to the windings 30a,30b,30a',30b'; to achieve this each wire which defines a respective winding 30a,30b,30a',30b' of the stator is directly connected to one or more electrical contacts 5a-h on the first connecting portion. Preferably each wire is soldered to an electrical contact 5a-h on the first connecting portion 2. It can be that each winding 30a,30b,30a',30b' is defined by two wires, and the two wires of each winding may be directly connected to one or more electrical contacts 5a-h on the first connecting portion 2. Alternatively conductor wires will be used to electrically connect the electrical contacts 5a-d to windings 30a,30b,30a',30b'; the conductor wires may each be attached by soldering to a electrical contact 5a-h and winding 30a,30b,30a',30b'.

The user then chooses which of the second or third connecting portions 3,13 to use to connect to the driver. For example, for the PCB strip 118 of Figure 2 the user may choose the second or third connecting portions 3,13 depending on the desired length of the PCB strip; the desired length may be dictated by the desired distance between the stator and driver for example; to allow for larger distance between the stator and driver the user would choose the second connecting portion 13, or for a shorter distance between the stator and driver the user would choose the third connecting portion 13, since the length 21a of the third connecting portion 13 is shorter than the length 22a of the second connecting portion 2. For the PCB strip 119 of Figure 3 the user may choose the second or third connecting portions 3,13 depending on the relative positioning of the driver and stator; for example if the driver is to be positioned to the left of the stator then the user may select to use the second connecting portion 3 to connect to the driver; or if the driver is to be position to the right of the stator then the user may select the third connecting portion 13 to connect to the driver.

After the user has selected which of the second or third connecting portions 3,13 to use to connect to the driver the user then removes the other connecting portion 3,13 by cutting the PCB strip 118,119 at the appropriate first or second cutting zones 20d, 20b; to remove the second connecting portion 3 the user cuts the PCB strip 118,119 at the first cutting zone 20d and to remove the third connecting portion 13 the user cuts the PCB strip 118,119 at the second cutting zone 20b.

Once the second or third connecting portion 3,13 has been removed the user then chooses which of the connecting zones 15a-d, on the remaining connecting portion 3,13, whose electrical contacts 16a-d are to be electrically connected to a driver. If the user chooses connecting zone 15a, which is the connecting zone closest to the free end 17 of the PCB strip 118,119 then the electrical contacts 16a-d of that connecting zone 15a may be then electrically connected to the driver without any further steps. However if the user chooses another connecting zone 15a-d whose electrical contacts 16a-d are to be connected to the driver, then the user cuts the PCB strip 118,119 at the cutting region 6a-d which is at the end extremity of a chosen connecting zone 15a-d; the PCB strip 118,119 is thus cut so that chosen connecting zone 15a-d is made to be closest to the free end 17 of the PCB strip. The electrical contacts 16a-d of the chosen connecting zone 15a-d are then electrically connected to the driver.

In a variation of the illustrative examples not part of the present invention shown in Figures 2 and 3, it will be understood that the PCB strip 118,119 could comprise more than three connecting portions each of which is suitable for connecting to a driver. The PCB strip 118,119 would comprise a cutting zone for each of the connecting portions, so that PCB strip 118,119 could be selectively cut to selectively remove a corresponding connecting portion from the PCB strip 118,119.

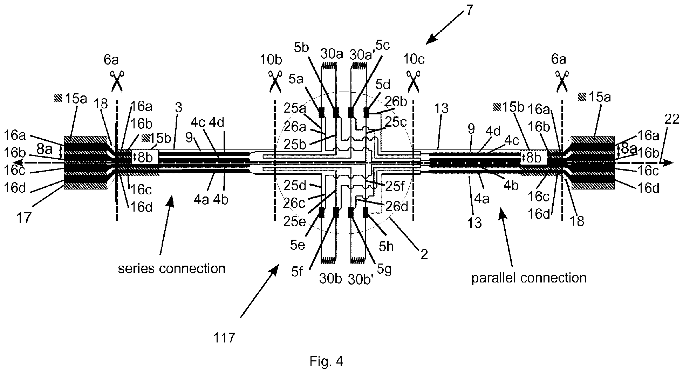

Fig. 4 shows a plan view of a PBC strip 117 according to an embodiment of the present invention. The PBC strip 117 comprises many of the same features and variations as the PCB strip 118,119 shown in Figures 2 and 3 and like features are awarded the same reference numbers. In particular, as was the case for the PCB strips 118,119 shown in Figures 2 and 3 respectively, the PCB strip 117 shown in Figure 4 comprises a second and third connecting portions 3,13 each of which may comprise some or all of the features of the second connecting portion 3 of the PCB strip 1 shown in Figure 1, and like features are awarded the same reference numbers.

The first connecting portion 2 comprises eight electrical contacts 5ah. The electrical contacts 5a-h are electrically connected so as to provide two selectable electrical configurations. The PCB strip 117 comprises a first cutting zone 10b at which the PCB strip can be cut to select one of the two selectable electrical configurations for the electrical contacts 5a-h, and a second cutting zone 10c at which the PCB strip 117 can be cut to select the other of the at least two selectable electrical configurations for the electrical contacts 5a-h.

In this example the first electrical configuration of the electrical contacts 5a-h is such that when electrical contacts 5a-h of the first portion 2 are connected to the windings 30a,30a',30b',30b' of the stator those windings 30a,30a',30b',30b' are connected electrically in parallel, and the second electrical configuration of the electrical contacts 5a-h is such that when electrical contacts 5a-h of the first connecting portion 2 are connected to windings 30a,30a',30b',30b' of the stator those windings are connected electrically in series 30a,30a',30b',30b'. In an alternative illustrative example not part of the present invention the first electrical configuration of the electrical contacts 5a-h may be such that when electrical contacts 5a-h of the first portion 2 are connected to windings 30a,30a',30b',30b'of the stator those windings 30a,30a',30b',30b' are connected electrically in a unipolar configuration, and the second electrical configuration of the electrical contacts 5a-h may be such that when the electrical contacts 5a-h of the first portion are connected to windings 30a,30a',30b',30b'of the stator those windings 30a,30a',30b',30b'are connected electrically in a bipolar configuration.

In particular, the PCB strip 117 comprises: a first electrical contact 5a and a first conductor 25a which electrically connects the first electrical contact 5a to a first conductor 4d in the second connecting portion 3; a second and third electrical contact 5b,5c and a second conductor 25b, wherein the second electrical contact 5b is electrically connected to the third electrical contact 5c by the second conductor 25b; a fourth electrical contact 5d and a third conductor 25c which electrically connects the fourth electrical contact 5d to a second conductor 4c in the second connecting portion 2; a fifth electrical contact 5e and a fourth conductor 25d which electrically connects the fifth electrical contact 5e to a third conductor 4b in the second connecting portion 2; a sixth and seventh electrical contact 5f,5g and a fifth conductor 25e, wherein the sixth electrical contact 5f is electrically connected to the seventh electrical contact 5g by the fifth conductor 25e; an eight electrical contact 5h and a sixth conductor 25f) which electrically connects the eight electrical contact 5h to a fourth conductor 4a in the second connecting portion 2.

The PCB strip 117 further comprises a seventh conductor 26a which electrically connects the first and third electrical contacts 5a,5c and is electrically connected to a first conductor 4d in the third connecting portion 13; an eight conductor 26b which electrically connects the second and fourth electrical contacts 5b,d and is electrically connected to a second conductor 4c in the third connecting portion 13; a ninth conductor 26c which electrically connects the fifth and seventh electrical contacts 5e,5g and is electrically connected to a third conductor 4b in the third connecting portion 13; and a tenth conductor 26d which electrically connects the sixth and eight electrical contacts 5f,5h and is electrically connected to a fourth conductor 4a in the third connecting portion 13.

The first cutting zone 10b is provided at a junction between the first connecting portion 2 and the second connecting portion 3 and the second cutting zone 10c is provided at a junction between the first connecting portion 2 and the third connecting portion 13. The first, second, third, fourth, fifth and sixth electrical conductors are each arranged to traverse the first cutting zone 10b only, and not the second cutting zone 10c. The seventh, eight, ninth, and tenth conductor are each arranged to traverse the second cutting zone 10c only, and not the first cutting zone 10b. This allows the first or second electrical configurations for the electrical contacts 5a-h to be selected by cutting at the first or second cutting zones 10b,10c respectively.

During use a user may wrap the flexible first connecting portion 2 around a stator so that the electrical contacts 5a-h on the first connecting portion 2 can be electrically connected to the windings 30a,30a',30b',30b' of the stator by soldering; to achieve this each wire which defines a respective winding 30a,30b,30a',30b' of the stator is directly connected to one or more electrical contacts 5a-h on the first connecting portion. Preferably each wire is soldered to an electrical contact 5a-h on the first connecting portion 2. It can be that each winding 30a,30b,30a',30b' is defined by two or more wires, and the two or more wires of each winding may be directly connected to one or more electrical contacts 5a-h on the first connecting portion 2. In this example the stator is preferably configured to have a cylindrical profile with the windings of the stator, arranged to in a cylindrical pattern (i.e. lie on a cylindrical plane). Preferably in this case the first connecting portion 2 will have a rectangular profile. In an alternative embodiment the windings of the stator, may be accessible from a flat face of the cylindrical profiled stator; preferably in this case the first connecting portion 2 will have a circular profile which matches the profile of circular face of the stator, and the positions of the electrical contacts 5a-h on the first connecting portion 2 will correspond to the positions of the windings of the stator in their cylindrical pattern.

The user then chooses from the two selectable electrical configurations for the electrical contacts 5a-h; in this particular example the user chooses whether to connect the windings of the stator in parallel or in series. If the user chooses to connect the windings of the stator in parallel, then the user must then cut the PCB strip 117 along the first cutting zone 10b; since the first, second, third, fourth, fifth and sixth electrical conductors of the first connecting portion 2 are each arranged to traverse the first cutting zone 10b only and not the second cutting zone 10c, by cutting the PCB strip 117 along the first cutting region 10b the first, second, third, fourth, fifth and sixth electrical conductors are cut to create an open circuit between the first, second, third, fourth, fifth and sixth electrical conductors. Since the seventh, eight, ninth, and tenth conductors are each arranged to traverse the second cutting zone 10c only and not the first cutting zone 10b, the seventh, eight, ninth, and tenth conductors will not be cut when the PCB strip 117 is cut along the first cutting region 10b. Thus all current flowing from the driver will flow through the seventh, eight, ninth, and tenth conductors to the windings 30a,30a',30b',30b' of the stator. Accordingly by cutting the PCB strip 117 at the first cutting zone the user will select the parallel electrical configuration for the windings 30a,30a',30b',30b' of the stator.

Alternatively if the user chooses to connect the windings of the stator in series, then the user must then cut the PCB strip 117 along the second cutting region 10c; since the seventh, eight, ninth, and tenth conductors are each arranged to traverse the second cutting zone 10c only and not the first cutting zone 10b, by cutting the PCB strip 117 along the second cutting zone 10c the seventh, eight, ninth, and tenth electrical conductors are cut to create an open circuit between the seventh, eight, ninth, and tenth conductors. Since the first, second, third, fourth, fifth and sixth electrical conductors are each arranged to traverse the first cutting zone 10b only and not the second cutting zone 10c, the first, second, third, fourth, fifth and sixth electrical conductors will not be cut when the PCB strip 117 is cut along the second cutting zone 10c. Thus all current flowing from the driver will flow through the first, second, third, fourth, fifth and sixth electrical conductors to the windings 30a,30a',30b',30b' of the stator. Accordingly by cutting the PCB strip 117 at the second cutting zone 10c the user will select the series electrical configuration for the windings 30a,30a',30b',30b' of the stator.

Once the second or third connecting portion 3,13 has been removed from the PCB strip 117, the user then chooses which of the connecting zones 15a-d, on the remaining connecting portion 3,13, whose electrical contacts 16a-d are to be electrically connected to the driver. If the user chooses connecting zone 15a, which is the connecting zone closest to the free end 17 of the PCB strip 117, then the electrical contacts 16a-d of that connecting zone 15a may be then electrically connected to the driver without any further steps. However, if the user chooses another connecting zone 15a-d whose electrical contacts 16a-d are to be connected to the driver, then the user cuts the PCB strip 117 at the cutting region 6a-d which is at the end extremity of a chosen connecting zone 15a-d; the PCB strip 117 is thus cut so that chosen connecting zone 15a-d is made to be closest to the free end 17 of the PCB strip. The electrical contacts 16a-d of the chosen connecting zone 15a-d are then electrically connected to the driver.

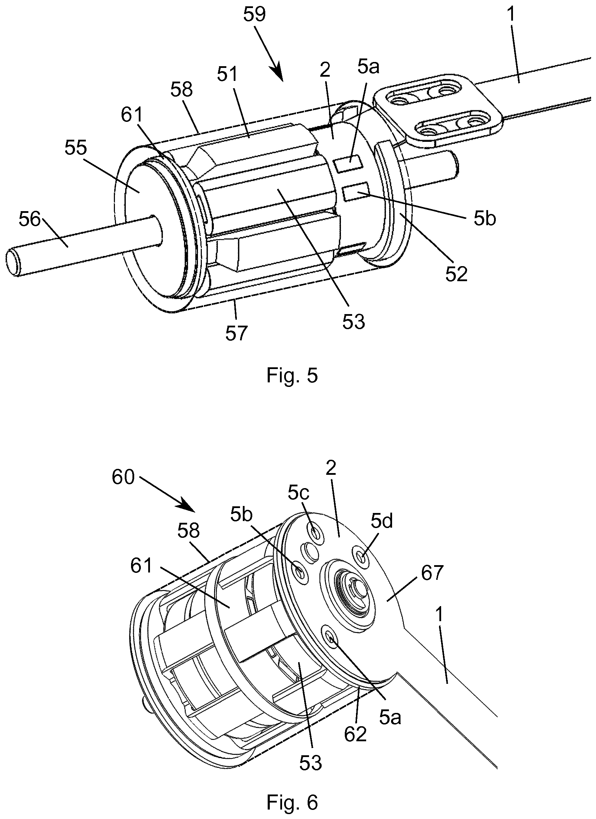

Fig. 5 shows a perspective view of an assembly 59 according to an illustrative example not part of the present invention.

The assembly 59 comprises a stepping motor 51 which comprises a stator 52 which comprises windings 53, and a PCB strip 1 having the same features as the PCB strip shown in Figure 1. The first connecting portion 2 is arranged to be wrapped around the stator 52 so that electrical contacts 5a-d on the first connecting portion can be electrically connected to a windings 53 of the stator. The electrical contacts 5a-d on the first may be directly connected to the windings 53; to achieve this each wire which defines a respective winding 53 of the stator is directly connected to one or more electrical contacts 5a-d on the first connecting portion 2. Preferably each wire is soldered to an electrical contact 5a-d on the first connecting portion 2. It can be that each winding 53 is defined by two or more wires, and the two or more wires of each winding may be directly connected to one or more electrical contacts 5a-d on the first connecting portion 2. Alternatively, conductor wires will be used to electrically connect the electrical contacts 5a-d to windings 53; the conductor wires may each be attached by soldering to a electrical contact 5a-d and winding 53.

The stepping motor 51 further comprises a rotor 55 which comprises a shaft 56 and a permanent magnet 61. The second connecting portion 3 is arranged to extend axially from the stator 52, parallel to the shaft 56.

The assembly 59 further comprises a housing 57 in which stator 52 is housed. In this example the housing 57 is a tubular structure; however it will be understood that the housing 57 may take any suitable configuration. The first connecting portion 2 of the PCB strip 1 is located between the stator 52 and an inner surface 58 of the housing 57. In a variation of the illustrative example not part of the present invention the first connection portion 2 lines on a plane which is parallel to a plane along the cross section of the tubular housing.

Fig. 6 shows a perspective view of an assembly 60 according to a further illustrative example not part of the present invention. The assembly 60 has many of the same features as the assembly shown in Figure 5 and like features are awarded the same reference numbers. As was the case for the assembly 59 shown in Figure 5, the assembly 60 of Figure 6 comprises a stator 62 is configured to have a cylindrical profile. The stator 62 of the assembly 60 however further comprises winding electrical contacts (5a-d) for the windings 30a,30a',30b',30b' of the stator 62 which are provided on the cylindrical stator's circular face 67. The first connecting portion 2 is configured to have a circular profile which matches the profile of circular face 67 of the stator 62, and the positions of the electrical contacts 5a-d on the first connecting portion 2 correspond to the positions of the windings of the stator. Preferably the first connecting portion 2 is positioned such that each of its electrical contacts 5a-h are aligned with the a respective windings 30a,30a',30b',30b' on the circular face 67 of the stator 62. Either each of the electrical contacts 5a-h are connected directly to a respective winding 30a,30a',30b',30b', or alternatively conductor wires are soldered to each of the electrical contacts 5a-h and to the windings 30a,30a',30b',30b' so as to electrically connect the electrical contacts 5a-h to the windings 30a,30a',30b',30b' .

It will be understood that many features of the invention were described with reference to different embodiments. However, it should be understood that each one of the above-described embodiments may have features of the other embodiments described.

Various modifications and variations to the described embodiments of the invention will be apparent to those skilled in the art without departing from the scope of the invention as defined in the appended claims. Although the invention has been described in connection with specific preferred embodiments, it should be understood that the invention as claimed should not be unduly limited to such specific embodiment.

## Claims

1. A PCB strip (117) comprising: a first connecting portion (2) which comprises a plurality of electrical contacts (5ah) which can be electrically connected to windings on a stator,
a second connecting portion (3) which can be electrically connected to a driver, and
a third connecting portion (13) which can be electrically connected to a driver;
wherein, said plurality of electrical contacts (5a-d) are electrically connected so as to provide two selectable electrical configurations;
wherein the PCB strip (117) further comprises a first cutting zone (10b) at which the PCB strip can be cut to select one of the two selectable electrical configurations for the electrical contacts (5a-d) of the first connecting portion (2), and a second cutting zone (10c) at which the PCB strip (117) can be cut to select the other of the at least two selectable electrical configurations for the electrical contacts (5a-h) of the first connecting portion (2),
**characterized in that** the at least two selectable electrical configurations comprise:
a first electrical configuration which is such that when electrical contacts of the first portion are connected to windings of the stator those windings are connected electrically in parallel, and
a second electrical configuration which is such that when electrical contacts of the first portion are connected to windings of the stator those windings are connected electrically in series.

2. A PCB strip (117) according to claim 1, wherein the PCB strip (117) comprises: a first electrical contact (5a) and a first conductor (25a) which electrically connects the first electrical contact (5a) to a first conductor (4d) in the second connecting portion (3);
a second and third electrical contact (5b,5c) and a second conductor (25b), wherein the second electrical contact (5b) is electrically connected to the third electrical contact (5c) by the second conductor (25b); a fourth electrical contact (5d) and a third conductor (25c) which electrically connects the fourth electrical contact (5d) to a second conductor (4c) in the second connecting portion (2); a fifth electrical contact (5e) and a fourth conductor (25d) which electrically connects the fifth electrical contact (5e) to a third conductor (4b) in the second connecting portion (2);
a sixth and seventh electrical contact (5f,5g) and a fifth conductor (25e), wherein the sixth electrical contact (5f) is electrically connected to the seventh electrical contact (5g) by the fifth conductor (25e); an eight electrical contact (5h) and a sixth conductor (25f) which electrically connects the eight electrical contact (5h) to a fourth conductor (4a) in the second connecting portion (2).

3. A PCB strip (117) according to claim 2, wherein the PCB strip further comprises, a seventh conductor (26a) which electrically connects the first and third electrical contacts (5a,5c) and is electrically connected to a first conductor (4d) in the third connecting portion (13); an eight conductor (26b) which electrically connects the second and fourth electrical contacts (5b,d) and is electrically connected to a second conductor (4c) in the third connecting portion (13); a ninth conductor (26c) which electrically connects the fifth and seventh electrical contacts (5e,5g) and is electrically connected to a third conductor (4b) in the third connecting portion (13); a tenth conductor (26d) which electrically connects the sixth and eight electrical contacts (5f,5h) and is electrically connected to a fourth conductor (4a) in the third connecting portion (13).

4. An assembly (59) comprising an electrical motor (51) which comprises a stator (52) which comprises windings (53), and a PCB strip according to any one of the preceding claims.

5. A method of manufacturing an assembly which comprises a stator and a PCB strip (117) according to any one of claims 1 to 3, the method comprising the following steps (a) electrically connecting electrical contacts of the first connecting portion (3) to the windings of a stator (b) choosing an electrical configuration for the windings of a stator; (c) cutting the PCB strip (117) at the first cutting zone if the first electrical configuration corresponds to the chosen configuration for the windings of a stator, or cutting the PCB strip (117) at the second cutting zone if the second electrical configuration corresponds to the chosen configuration for the windings of a stator.

## Patentansprüche

1. Leiterplattenstreifen (117), umfassend:
einen ersten Verbindungsabschnitt (2), der eine Vielzahl von elektrischen Kontakten (5a-h) umfasst, die elektrisch mit Wicklungen auf einem Stator verbunden werden können,
einen zweiten Verbindungsabschnitt (3), der elektrisch mit einem Treiber verbunden werden kann, und
einen dritten Verbindungsabschnitt (13), der elektrisch mit einem Treiber verbunden werden kann;
wobei die Vielzahl von elektrischen Kontakten (5a-d) elektrisch so verbunden sind, dass sie zwei auswählbare elektrische Konfigurationen bereitstellen;
wobei der Leiterplattenstreifen (117) ferner eine erste Schneidzone (10b), an der der Leiterplattenstreifen geschnitten werden kann, um eine der zwei auswählbaren elektrischen Konfigurationen für die elektrischen Kontakte (5a-d) des ersten Verbindungsabschnitts (2) auszuwählen, und eine zweite Schneidzone (10c) umfasst, an der der Leiterplattenstreifen (117) geschnitten werden kann, um die andere der mindestens zwei auswählbaren elektrischen Konfigurationen für die elektrischen Kontakte (5a-h) des ersten Verbindungsabschnitts (2) auszuwählen,
**dadurch gekennzeichnet, dass** die mindestens zwei wählbaren elektrischen Konfigurationen umfassen:
eine erste elektrische Konfiguration, die so beschaffen ist, dass, wenn elektrische Kontakte des ersten Abschnitts mit Wicklungen des Stators verbunden sind, diese Wicklungen elektrisch parallel geschaltet sind, und eine zweite elektrische Konfiguration, die so beschaffen ist, dass, wenn elektrische Kontakte des ersten Abschnitts mit Wicklungen des Stators verbunden sind, diese Wicklungen elektrisch in Reihe geschaltet sind.

2. Leiterplattenstreifen (117) gemäß Anspruch 1, wobei der Leiterplattenstreifen (117) umfasst:
einen ersten elektrischen Kontakt (5a) und einen ersten Leiter (25a), der den ersten elektrischen Kontakt (5a) mit einem ersten Leiter (4d) in dem zweiten Verbindungsabschnitt (3) elektrisch verbindet;
einen zweiten und dritten elektrischen Kontakt (5b, 5c) und einen zweiten Leiter (25b), wobei der zweite elektrische Kontakt (5b) mit dem dritten elektrischen Kontakt (5c) über den zweiten Leiter (25b) elektrisch verbunden ist;
einen vierten elektrischen Kontakt (5d) und einen dritten Leiter (25c), der den vierten elektrischen Kontakt (5d) mit einem zweiten Leiter (4c) in dem zweiten Verbindungsabschnitt (2) elektrisch verbindet;
einen fünften elektrischen Kontakt (5e) und einen vierten Leiter (25d), der den fünften elektrischen Kontakt (5e) mit einem dritten Leiter (4b) in dem zweiten Verbindungsabschnitt (2) elektrisch verbindet;
einen sechsten und siebten elektrischen Kontakt (5f, 5g) und einen fünften Leiter (25e), wobei der sechste elektrische Kontakt (5f) mit dem siebten elektrischen Kontakt (5g) durch den fünften Leiter (25e) elektrisch verbunden ist;
einen achten elektrischen Kontakt (5h) und einen sechsten Leiter (25f), der den achten elektrischen Kontakt (5h) mit einem vierten Leiter (4a) in dem zweiten Verbindungsabschnitt (2) elektrisch verbindet.

3. Leiterplattenstreifen (117) gemäß Anspruch 2, wobei der Leiterplattenstreifen ferner umfasst:
einen siebten Leiter (26a), der den ersten und dritten elektrischen Kontakt (5a, 5c) elektrisch verbindet und mit einem ersten Leiter (4d) in dem dritten Verbindungsabschnitt (13) elektrisch verbunden ist;
einen achten Leiter (26b), der den zweiten und vierten elektrischen Kontakt (5b, d) elektrisch verbindet und mit einem zweiten Leiter (4c) im dritten Verbindungsabschnitt (13) elektrisch verbunden ist;
einen neunten Leiter (26c), der den fünften und siebten elektrischen Kontakt (5e, 5g) elektrisch verbindet und
mit einem dritten Leiter (4b) in dem dritten Verbindungsabschnitt (13) elektrisch verbunden ist;
einen zehnten Leiter (26d), der den sechsten und achten elektrischen Kontakt (5f, 5h) elektrisch verbindet und
mit einem vierten Leiter (4a) in dem dritten Verbindungsabschnitt (13) elektrisch verbunden ist.

4. Anordnung (59) umfassend einen Elektromotor (51) mit einem Stator (52) mit Wicklungen (53) und einem Leiterplattenstreifen gemäß einem der vorhergehenden Ansprüche.

5. Verfahren zur Herstellung einer Anordnung, die einen Stator und einen Leiterplattenstreifen (117) gemäß einem der Ansprüche 1 bis 3 umfasst, wobei das Verfahren die folgenden Schritte umfasst:
(a) elektrisches Verbinden von elektrischen Kontakten des ersten Verbindungsabschnitts (3) mit den Wicklungen eines Stators;
(b) Auswählen einer elektrischen Konfiguration für die Wicklungen eines Stators;
(c) Schneiden des Leiterplattenstreifens (117) in der ersten Schneidzone, falls die erste elektrische Konfiguration der ausgewählten Konfiguration für die Wicklungen eines Stators entspricht, oder Schneiden des Leiterplattenstreifens (117) in der zweiten Schneidzone, wenn die zweite elektrische Konfiguration der ausgewählten Konfiguration für die Wicklungen eines Stators entspricht.

## Revendications

1. Bande (117) de PCB comportant :
une première partie (2) de liaison qui comporte une pluralité de contacts électriques (5a-h) qui peuvent être reliés électriquement à des enroulements sur un stator,
une deuxième partie (3) de liaison qui peut être reliée électriquement à un contrôleur, et
une troisième partie (13) de liaison qui peut être reliée électriquement à un contrôleur ;
ladite pluralité de contacts électriques (5a-d) étant reliée électriquement de façon à fournir deux configurations électriques sélectionnables ;
la bande (117) de PCB comportant en outre une première zone (10b) de coupure au niveau de laquelle la bande de PCB peut être coupée pour sélectionner une des deux configurations électriques sélectionnables pour les contacts électriques (5a-d) de la première partie (2) de liaison, et une deuxième zone (10c) de coupure au niveau de laquelle la bande (117) de PCB peut être coupée pour sélectionner l'autre desdites au moins deux configurations électriques sélectionnables pour les contacts électriques (5a-h) de la première partie (2) de liaison,
**caractérisée en ce que** lesdites au moins deux configurations électriques sélectionnables comportent :
une première configuration électrique qui est telle que lorsque des contacts électriques de la première partie sont reliés à des enroulements du stator, ces enroulements sont reliés électriquement en parallèle, et
une deuxième configuration électrique qui est telle que lorsque des contacts électriques de la première partie sont reliés à des enroulements du stator, ces enroulements sont reliés électriquement en série.

2. Bande (117) de PCB selon la revendication 1, la bande (117) de PCB comportant :
un premier contact électrique (5a) et un premier conducteur (25a) qui relie électriquement le premier contact électrique (5a) à un premier conducteur (4d) dans la deuxième partie (3) de liaison ;
un deuxième et troisième contact électrique (5b, 5c) et
un deuxième conducteur (25b), le deuxième contact électrique (5b) étant relié électriquement au troisième contact électrique (5c) par le deuxième conducteur (25b) ;
un quatrième contact électrique (5d) et un troisième conducteur (25c) qui relie électriquement le quatrième contact électrique (5d) à un deuxième conducteur (4c) dans la deuxième partie (2) de liaison ;
un cinquième contact électrique (5e) et un quatrième conducteur (25d) qui relie électriquement le cinquième contact électrique (5e) à un troisième conducteur (4b) dans la deuxième partie (2) de liaison ;
un sixième et un septième contact électrique (5f, 5g) et
un cinquième conducteur (25e), le sixième contact électrique (5f) étant relié électriquement au septième contact électrique (5g) par le cinquième conducteur (25e) ;
un huitième contact électrique (5h) et un sixième conducteur (25f) qui relie électriquement le huitième contact électrique (5h) à un quatrième conducteur (4a) dans la deuxième partie (2) de liaison.

3. Bande (117) de PCB selon la revendication 2, la bande de PCB comportant en outre
un septième conducteur (26a) qui relie électriquement les premier et troisième contacts électriques (5a, 5c) et est relié électriquement à un premier conducteur (4d) dans la troisième partie (13) de liaison ;
un huitième conducteur (26b) qui relie électriquement les deuxième et quatrième contacts électriques (5b, 5d) et est relié électriquement à un deuxième conducteur (4c) dans la troisième partie (13) de liaison ;
un neuvième conducteur (26c) qui relie électriquement les cinquième et septième contacts électriques (5e, 5g) et est relié électriquement à un troisième conducteur (4b) dans la troisième partie (13) de liaison ;
un dixième conducteur (26d) qui relie électriquement les sixième et huitième contacts électriques (5f, 5h) et est relié électriquement à un quatrième conducteur (4a) dans la troisième partie (13) de liaison.

4. Ensemble (59) comportant un moteur électrique (51) qui comporte un stator (52) comportant des enroulements (53), et une bande de PCB selon l'une quelconque des revendications précédentes.

5. Procédé de fabrication d'un ensemble qui comporte un stator et une bande (117) de PCB selon l'une quelconque des revendications 1 à 3, le procédé comportant les étapes suivantes :
(a) relier électriquement des contacts électriques de la première partie (3) de liaison aux enroulements d'un stator
(b) choisir une configuration électrique pour les enroulements d'un stator ;
(c) couper la bande (117) de PCB au niveau de la première zone de coupure si la première configuration électrique correspond à la configuration choisie pour les enroulements d'un stator, ou couper la bande (117) de PCB au niveau de la deuxième zone de coupure si la deuxième configuration électrique correspond à la configuration choisie pour les enroulements d'un stator.
